# EUROPEAN PATENT APPLICATION

(11) **EP 4 231 364 A1**
(43) Date of publication of application: **23.08.2023**
(21) Application number: 22871100.8
(22) Date of filing: 28.07.2022
(51) Int. Cl.: H01L 31/0747

(54) **HETEROJUNCTION SOLAR CELL, PREPARATION METHOD THEREOF AND POWER GENERATION APPARATUS**

(30) Priority: 30.12.2021 CN 202111667805
(71) Applicant: Zhongwei New Energy (Chengdu) Co., Ltd., Chengdu, Sichuan 610225 (CN)
(72) Inventor: LAN, Shihu, Chengdu, Sichuan 610299 (CN); ZHANG, Liping, Chengdu, Sichuan 610299 (CN); ZHAO, Hui, Chengdu, Sichuan 610299 (CN); ZHANG, Haichuan, Chengdu, Sichuan 610299 (CN); SHI, Jianhua, Chengdu, Sichuan 610299 (CN); FU, Haoxin, Chengdu, Sichuan 610299 (CN); MENG, Fanying, Chengdu, Sichuan 610299 (CN); LIU, Zhengxin, Chengdu, Sichuan 610299 (CN)
(74) Representative: Marks & Clerk LLP
(86) International application number: PCT/CN2022/108484
(87) International publication number: WO 2023/124048

(57) **Abstract**

The present disclosure relates to a heterojunction solar cell, including a substrate layer, a first passivation layer, a second passivation layer, an emission member, and a back surface field member. The emission member and the back field member each include a doped layer, a conducting layer, and an electrode layer sequentially disposed along the direction away from the substrate layer. One or both of the emission member and the back surface field member include an electrical contact reinforced structure. The electrical contact reinforced structure is a first doped region and a second doped region of the doped layer. The second doped region is disposed beside the first doped region and is shielded by the electrode layer. One or both of the doping concentration and the crystallization degree of the second doped regions are higher than those of the first doped region.

## Description

### CROSS-REFERENCE TO RELATED APPLICATION

This application claims priority to Chinese patent application No. 2021116678058, filed on December 30, 2021, and titled "HETEROJUNCTION SOLAR CELL, PREPARATION METHOD THEREOF AND POWER GENERATION DEVICE", the content of which is hereby incorporated herein in its entirety by reference.

### TECHNICAL FIELD

The present application relates to the technical field of solar cells, and particularly to a heterojunction solar cell, a preparation method thereof, and a power generation device.

### BACKGROUND

A silicon heterojunction solar cell usually includes a doped amorphous silicon layer and an N-type monocrystalline silicon layer that constitute a heterojunction, and an intrinsic amorphous silicon layer interposed therebetween, which can achieve a good passivation effect at the heterojunction interfaces. The silicon heterojunction solar cell has the advantages such as low-temperature preparation, high open-circuit voltage, good temperature characteristic, thin silicon wafer, etc.

For a solar cell, there are three important parameters, i.e., the open-circuit voltage, the short-circuit current, and the fill factor (FF). The fill factor is the ratio of the product of the current and voltage at the maximum output power to the product of the short-circuit current and the open-circuit voltage. The short-circuit current and the open-circuit voltage are also two most important parameters of a solar cell, and the higher short-circuit current and open-circuit voltage are the basis for a higher energy conversion efficiency. When the open-circuit voltage and the short-circuit current are fixed, the conversion efficiency of the solar cell depends on the fill factor. The higher the fill factor, the higher the energy conversion efficiency.

For a heterojunction solar cell, increasing the doping concentration and thickness of a doped amorphous silicon layer can improve the conductivity of the doped amorphous silicon layer, and thus increase the fill factor. However, increasing the doping concentration of the amorphous silicon layer also promotes impurity diffusion into the passivation layer, so that a passivation effect of the passivation layer is reduced and thus the open-circuit voltage of the heterojunction solar cell is decreased. Moreover, excessive impurities may cause defects in the passivation layer, resulting in recombination of the photo-generated carriers, and thus reducing the short-circuit current.

### SUMMARY

According to some embodiments of the present disclosure, a heterojunction solar cell is provided. The heterojunction solar cell includes a substrate layer, a first passivation layer, a second passivation layer, an emission member, and a back surface field member.

The doping type of the substrate layer is N-type or P-type. The first passivation layer is disposed on a first surface of the substrate layer. The emission member is disposed on a surface of the first passivation layer away from the substrate layer. The second passivation layer is disposed on a second surface of the substrate layer opposite to the first surface. The back surface field member is disposed on a surface of the second passivation layer away from the substrate layer. The emission member and the back surface field member each include a doped layer, a conducting layer, and an electrode layer sequentially disposed along the direction away from the substrate layer. The doping type of the doped layer in the back surface field member is the same as the doping type of the substrate layer, and the doping type of the doped layer in the emission member is opposite to the doping type of the substrate layer.

One or both of the emission member and the back surface field member include an electrical contact reinforced structure, and the electrical contact reinforced structure is a first doped region and a second doped region of the doped layer, wherein the second doped region is disposed beside the first doped region and is shielded by the electrode layer, and one or both of the doping concentration and the crystallization degree of the second doped region are higher than those of the first doped region.

In some embodiments of the present disclosure, the electrode layer includes a grid line electrode, the second doped region is shielded by the grid line electrode, and a width of the grid line electrode is larger than a width of the second doped region.

In some embodiments of the present disclosure, the second doped region is a plurality of second doped regions that are disposed at intervals; the grid line electrode is a plurality of grid line electrodes that are disposed at intervals.

In some embodiments of the present disclosure, the width of the second doped region is 5µm to 200µm.

In some embodiments of the present disclosure, the second doped region is exposed from a surface of the doped layer away from the substrate layer and is in contact with the conducting layer.

In some embodiments of the present disclosure, the doped layer in the emission member is an emission doped layer, the first doped region in the emission doped layer is made of doped amorphous silicon, and the emission doped layer has a thickness of 6nm to 15nm.

In some embodiments of the present disclosure, the first doped region in the emission doped layer is made of doped microcrystalline silicon, and the emission doped layer has a thickness of 15nm to 30nm.

In some embodiments of the present disclosure, the doped layer in the back surface field member is a back surface field doped layer, the first doped region in the back surface field doped layer is made of doped amorphous silicon, and the back surface field doped layer has a thickness of 4nm to 10nm.

In some embodiments of the present disclosure, the first doped region in the back surface field doped layer is made of doped microcrystalline silicon, and the back surface field doped layer has a thickness of 15nm to 30nm.

According to some other embodiments of the present disclosure, a method for preparing a heterojunction solar cell is provided. In this method, the prepared heterojunction solar cell includes a substrate layer, a first passivation layer, a second passivation layer, an emission member, and a back surface field member.

The doping type of the substrate layer is a first doping type. The first passivation layer is disposed on a first surface of the substrate layer. The emission member is disposed on a surface of the first passivation layer away from the substrate layer. The second passivation layer is disposed on a second surface of the substrate layer opposite to the first surface. The back surface field member is disposed on a surface of the second passivation layer away from the substrate layer. The emission member and the back surface field member each include a doped layer, a conducting layer, and an electrode layer sequentially disposed along the direction away from the substrate layer. The doping type of the doped layer in the back surface field member is the first doping type, and the doping type of the doped layer in the emission member is a second doping type.

One or both of the emission member and the back surface field member include an electrical contact reinforced structure, and the method for forming the electrical contact reinforced structure includes one or both of step a and step b:

a. forming a precursor layer of the doped layer, and performing laser-doping on a predetermined region to increase doping concentration of the predetermined region, thereby forming the second doped region;

b. forming a precursor layer of the doped layer, and performing laser-induced crystallization on a predetermined region to increase crystallization degree of the predetermined region, thereby forming the second doped region.

In some embodiments of the present disclosure, in the electrical contact reinforced structure, both of the doping concentration and the crystallization degree of the second doped region are higher than those of the first doped region.

In some embodiments of the present disclosure, during the forming of the electrical contact reinforced structure, both the laser-doping and the laser-induced crystallization are performed on the second doped region at the same time.

In some embodiments of the present disclosure, the electrode layer includes a grid line electrode, the second doped region is shielded by the grid line electrode, and a width of the grid line electrode is larger than a width of the second doped region.

In some embodiments of the present disclosure, the second doped region is a plurality of second doped regions that are disposed at intervals; the grid line electrode is a plurality of grid line electrodes that are disposed at intervals.

In some embodiments of the present disclosure, the width of the second doped region is 5µm to 200µm.

In some embodiments of the present disclosure, the second doped region is exposed from a surface of the doped layer away from the substrate layer and is in contact with the conducting layer.

In some embodiments of the present disclosure, the doped layer in the emission member is an emission doped layer, the first doped region in the emission doped layer is made of doped amorphous silicon, and the emission doped layer has a thickness of 6nm to 15nm.

In some embodiments of the present disclosure, the first doped region in the emission doped layer is made of doped microcrystalline silicon, and the emission doped layer has a thickness of 15nm to 30nm.

In some embodiments of the present disclosure, the doped layer in the back surface field member is a back surface field doped layer, the first doped region in the back surface field doped layer is made of doped amorphous silicon, and the back surface field doped layer has a thickness of 4nm to 10nm.

In some embodiments of the present disclosure, the first doped region in the back surface field doped layer is made of doped microcrystalline silicon, and the back surface field doped layer has a thickness of 15nm to 30nm.

According to yet another embodiment of the present disclosure, a power generation device includes the heterojunction solar cell in any of the above embodiments.

The details of one or more embodiments of the present disclosure will be described in the accompanying drawings and the description below. Other features, objects and advantages of the present disclosure will be apparent from the description, drawing and claims.

### BRIEF DESCRIPTION OF THE DRAWINGS

In order to better describe and illustrate the embodiments and/ or examples of the present application, reference can be made to one or more accompanying drawings. The additional details or examples used to describe the drawings shall not be construed as limitations to the scope of any of the disclosed application, the presently described embodiments and/or examples, and the presently understood best modes of the application.

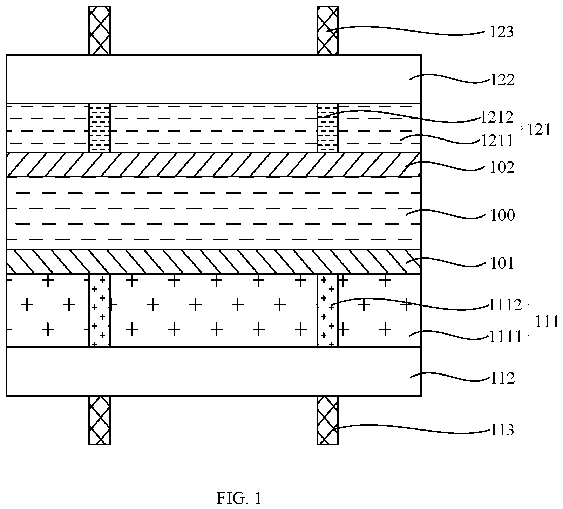

FIG. 1 is a schematic structural view of a heterojunction solar cell according to some embodiments.

The reference signs and their specific meanings are as follows.

100, substrate layer; 101, first passivation layer; 102, second passivation layer; 111, emission doped layer; 1111, first emission doped region; 1112, second emission doped region; 112, emission conducting layer; 113, emission electrode layer; 121, back surface field doped layer; 1211, first back surface field doped region; 1212, second back surface field doped region; 122, back surface field conducting layer; and 123, back surface field electrode layer.

### DETAILED DESCRIPTION

The present application will now be described in detail with reference to the accompanying drawing in order to facilitate understanding of the present application. An optimal embodiment of the present application is given in the drawing. However, the present application can be implemented in many different forms and is not limited to the embodiments described herein. It should be understood that these embodiments are provided to facilitate a more thorough understanding of the disclosure of the present application.

Furthermore, the terms "first" and "second" are used for illustrative purposes only and shall not to be construed as indicating or implying relative importance or implicitly indicating the number or order of the indicated technical features. Therefore, a technical feature limited by "first" or "second" can explicitly or implicitly include at least one of the feature. In the description herein, "a plurality of" means at least two, e.g., two, three, etc., unless expressly and specifically defined otherwise.

In describing positional relationships, unless otherwise specified, when an element, such as a layer, a film, or a substrate, is referred to as being "above" another film or layer, it can be directly above the other layer, or there may be an intermediate layer. Furthermore, when a layer is referred to as being "under" another layer, it may be directly under the other layer, or there may be one or more intermediate layers. It will also be appreciated that when a layer is referred to as being "between" two layers, it may be the only layer between the two layers, or there may be one or more intermediate layers.

Unless indicated to the contrary, the singular terms may include the plural forms as well and shall not to be understood as referring to a quantity of one.

Unless defined otherwise, all technical and scientific terms used herein have the same meanings as commonly understood by those ordinary skilled in the art to which the present application belongs. The terms used in the description of the present application are for the purpose of illustrating specific embodiments only and are not intended to limit the present application.

According to an embodiment of the present disclosure, a heterojunction solar cell includes a substrate layer, a first passivation layer, a second passivation layer, an emission member, and a back surface field member. The first passivation layer is disposed on a first surface of the substrate layer. The emission member is disposed on a surface of the first passivation layer away from the substrate layer. The second passivation layer is disposed on a second surface of the substrate layer opposite to the first surface. The back surface field member is disposed on a surface of the second passivation layer away from the substrate layer.

The emission member and the back surface field member each include a doped layer, a conducting layer, and an electrode layer sequentially disposed along the direction away from the substrate layer. The emission member and/or the back surface field member include an electrical contact reinforced structure. The electrical contact reinforced structure is a first doped region and a second doped region of the doped layer. The second doped region is disposed beside the first doped region and is shielded by the electrode layer. The doping concentration and/or the crystallization degree of the second doped region are higher than those of the first doped region.

In the above-described heterojunction solar cell, since the doping concentration and/or the crystallization degree of the second doped region is relatively high, the second doped region has relatively high electrical conductivity, and a good contact can be formed between the second doped region and the conducting layer and between the conducting layer and the electrode layer located directly above the second doped region, thereby increasing the fill factor of the heterojunction solar cell. Compared with increasing the doping concentration of the entire doped layer, only having the doping concentration of the second doped region increased can effectively reduce diffusion of impurities into the first passivation layer and/or the second passivation layer, and thus can suppress the decreasing of the open-circuit voltage or the short-circuit current.

It can be understood that increasing the crystallization degree of the second doped region allows the second doped region to have a better electrical contact with the conducting layer and the electrode layer located thereon, which increases the fill factor. Meanwhile, the increasing of the crystallization degree would not have a negative effect of impurity diffusion into the passivation layer, so that the problem of the decreased open-circuit voltage or short-circuit current can be avoided. The increasing of the doping concentration of the second doped region also allows the second doped region to have a better electrical contact with the conducting layer and the electrode layer located thereon. Although a high doping concentration of the second doped region may still cause the diffusion of impurities into the passivation layer, as compared with increasing the doping concentration of the entire doped layer, the amount of the impurities in the passivation layer can be greatly reduced by only increasing the doping concentration of the second doped region, and thus the problem of the reduced open-circuit voltage or short-circuit current can be effectively solved.

It can be understood that the doping type of the substrate layer is the first doping type, the doping type of the doped layer in the back surface field member is the first doping type, and the doping type of the doped layer in the emission member is the second doping type. Semiconductors include intrinsic semiconductors and doped semiconductors, where the doped semiconductors refer to doping on the basis of the intrinsic semiconductors. The doping type of the doped semiconductor is n-type doping or p-type doping. The first doping type and the second doping type are respectively selected from different doping types. For ease of description, the first doping type in this embodiment is n-type and the second doping type is p-type.

In this embodiment, as an alternative, the base material of the substrate layer can be silicon, and further preferably monocrystalline silicon. Specifically, the substrate layer is made of n-type monocrystalline silicon, and the first passivation layer, the second passivation layer, the emission member, and the back surface field member can be formed on the n-type monocrystalline silicon substrate layer. The substrate layer has a thickness of 50µm to 300µm.

In a specific embodiment, the base material of the first passivation layer can be an intrinsic semiconductor, such as intrinsic amorphous silicon. Similarly, the base material of the second passivation layer can also be an intrinsic semiconductor, such as intrinsic amorphous silicon. The first passivation layer and/or the second passivation layer can be made of hydrogen-containing intrinsic amorphous silicon. The first passivation layer and/or the second passivation layer can have a thickness of 1nm to 20nm, and mainly function as passivation. If not specifically noted, the passivation layer herein can be understood according to the context as "the first passivation layer and/or the second passivation layer".

It can be understood that, since the heterojunction solar cell has the advantage of structural symmetry, the emission member disposed on the first passivation layer and the back surface field member disposed on the second passivation layer each can include a doped layer, a conducting layer, and an electrode layer that are sequentially arranged. The doped layer refers to a semiconductor layer being subjected to a specific type of doping, and the base material of the doped layer can be amorphous silicon or microcrystalline silicon. The doping type of the doped layer in the back surface field member is n-type doping, which is the same as the doping type of the substrate layer; and the doping type of the doped layer in the emission member is p-type doping, which is different from the doping type of the substrate layer, to form a heterojunction with the substrate layer.

In a specific embodiment, the electrode layer includes a grid line electrode. The second doped region is shielded by the grid line electrode. The width of the grid line electrode is larger than the width of the second doped region. The grid line electrode refers to a line-shaped electrode disposed on the conducting layer. The grid line electrode can be used to collect photo-generated carriers generated by the solar cell. The width of the grid line electrode is greater than the width of the second doped region, and more specifically, the width of the second doped region is equal to or smaller than the width of the grid line electrode. In order to minimize the effect of the grid line electrode on light incident into the heterojunction, the width of the grid line electrode is usually designed to be small. Thus, by having the width of the grid line electrode greater than the width of the second doped region, not only a good electrical contact effect between the second doped region and the electrode layer can be ensued, but also introducing impurities into the passivation layer caused by the second doped region can be avoided as much as possible.

In a specific embodiment, there are a plurality of second doped regions disposed at intervals, and there are also a plurality of grid line electrodes disposed at intervals. The spaced grid line electrodes can enhance carrier collection ability. In the case of the second doped region with a relatively high doping concentration, the spaced second doped regions can enhance the electrical contact between the second doped region in the doped layer and the electrode layer, and avoid the concentrated local infiltration of impurities in the first passivation layer and/or the second passivation layer, thereby reducing the effect on the open-circuit voltage and the short-circuit current.

In a specific embodiment, the width of the second doped region can be 5µm to 200µm. Optionally, the width of the second doped region can be 8µm to 150µm. More preferably, the width of the second doped region can be 10µm to 100µm. The second doped region having the above width would not substantially introduce significant impurities in the passivation layer, and have a good electrical contact with the electrode layer.

In a specific embodiment, the second doped region is exposed from a surface of the doped layer away from the substrate layer, such that the second doped region can be in direct contact with the conducting layer. The thickness of the second doped region can be the same as that of the doped layer, or the thickness of the second doped region can be smaller than that of the doped layer. It can be understood that when the thickness of the second doped region is the same as that of the doped layer, a surface of the second doped region of the doped layer adjacent to the substrate layer is exposed. When the thickness of the second doped region is different from that of the doped layer, a first doped region is further disposed on the side of the second doped region adjacent to the substrate layer. Alternatively, the thickness of the second doped region is smaller than that of the doped layer, and the first doped region can function as buffer to some extent to reduce impurities infiltrating into the passivation layer.

In a specific embodiment, the doped layer in the emission member is an emissive doped layer. The first doped region in the emission doped layer is made of doped amorphous silicon. The thickness of the emission doped layer is 6nm to 15nm. It can be understood that in the emission doped layer, the doping concentration of the second doped region can be higher than that of the first doped region. Specifically, the doping concentration of the first doped region is 1×10⁸-1×10¹⁷/cm³, and the doping concentration of the second doped region is 1×10⁹-1×10²¹/cm³. Optionally, the doping concentration of the second doped region is 1×10¹⁰-5×10²⁰/cm³, and the doping concentration of the first doped region is 1×10⁹-5×10¹⁶/cm³. Further Optionally, the doping concentration of the second doped region is 1×10¹¹-1×10²⁰/cm³, and the doping concentration of the first doped region is 1×10⁹-1×10¹⁶/cm³. Since the electrical contact with the grid line electrode of the electrode layer is primarily through the second doped region, the second doped region can be formed into a p++ doped region by significantly increasing the doping concentration of the second doped region, thereby improving the field passivation and heterojunction effect so as to increase the open-circuit voltage of the heterojunction solar cell. In addition, compared with the emission doped layer in the conventional art, in the present emission doped layer, the doping concentration of the second doped region can be significantly increased, and the doping concentration of the first doped region can be appropriately reduced. Moreover, a corresponding layer thickness can be selected to reduce absorption of photo-generated carriers by the doped layer, so as to increase the short-circuit current of the heterojunction solar cell.

In a specific embodiment, in the emission doped layer, on the condition that the first doped region is made of doped amorphous silicon, the second doped region can be made of microcrystalline silicon, and the crystallinity of the second doped region can be 1% to 70%. In order to significantly improve the electrical conductivity thereof, the crystallinity of the second doped region can be 10% to 70%. Optionally, the crystallinity of the second doped region can be 30% to 70%. Further, the crystallinity of the second doped region can be 50% to 70%. It can be noted that the crystallinity can be obtained by conducting Raman tests on samples and calculating the intensity of the corresponding peaks.

Alternatively, in the emission doped layer, the first doped region can be made of doped microcrystalline silicon, and the thickness of the first doped region can be 15nm to 30nm. Microcrystalline silicon can have a relatively large thickness and a relatively high doping concentration. The doping concentration of the first doped region can be 1×10⁸-1×10¹⁷/cm³, and the doping concentration of the second doped region can be 1×10⁹-5×10²¹/cm³. Optionally, the doping concentration of the first doped region can be 1×10⁹-5×10¹⁶/cm³, and the doping concentration of the second doped region can be 1×10¹⁰-5×10²¹/cm³. Further optionally, the doping concentration of the first doped region can be 1×10⁹-1×10¹⁶/cm³, and the doping concentration of the second doped region can be 1×10¹⁰-1×10²¹/cm³.

In a specific embodiment, in the emission doped layer, on the condition that the first doped region is made of doped microcrystalline silicon, the crystallinity of the second doped region can be greater than that of the first doped region. For example, the crystallinity of the first doped region can be 5% to 50%, and the crystallinity of the second doped region can be 10% to 70%. Further, the crystallinity of the second doped region can be 15% to 70%. Alternatively, the crystallinity of the second doped region can be 30% to 70%. Further, the crystallinity of the second doped region can be 50% to 70%.

The doped layer in the emission member and the doped layer in the back surface field member can have different thicknesses. In a specific embodiment, the doped layer in the back surface field member can be a back surface field doped layer. Optionally, the first doped region in the back surface field doped layer can be made of doped amorphous silicon, and the thickness of the back surface field doped layer can be 4nm to 10nm. It can be understood that in the back surface field doped layer, the doping concentration of the second doped region can be higher than the doping concentration of the first doped region. Specifically, the doping concentration of the first doped region can be 1×10⁹-1×10¹⁹/cm³, and the doping concentration of the second doped region can be 1×10¹¹-1×10²¹/cm³. Optionally, the doping concentration of the second doped region can be 1×10¹²-5×10²⁰/cm³, and the doping concentration of the first doped region can be 1×10¹⁰-5×10¹⁸/cm³. Further optionally, the doping concentration of the second doped region can be 1×10¹²-1×10²⁰/cm³, and the doping concentration of the first doped region can be 1×10¹⁰-1×10¹⁸/cm³.

In addition, compared with the back surface field doped layer in the conventional art, in the present back surface field doped layer, the doping concentration of the second doped region can be significantly increased, and the doping concentration of the first doped region can be appropriately reduced. Moreover, a corresponding layer thickness can be selected to reduce absorption of photo-generated carriers by the doped layer, so as to increase the short-circuit current of the heterojunction solar cell.

In a specific embodiment, in the back surface field doped layer, on the condition that the first doped region is made of doped amorphous silicon, the second doped region can be made of crystalline silicon, and the crystallinity of the second doped region can be 1% to 70%. In order to significantly improve the electrical conductivity thereof, the crystallinity of the second doped region can be 10% to 70%. Optionally, the crystallinity of the second doped region can be 30% to 70%. Further, the crystallinity of the second doped region can be 50% to 70%.

Alternatively, in the back surface field doped layer, the first doped region of can be made of doped microcrystalline silicon, and the thickness of the first doped region can be 15nm to 30nm. Microcrystalline silicon can have a relatively large thickness and a relatively high doping concentration. The doping concentration of the first doped region can be 1×10⁹-1×10¹⁹/cm³, and the doping concentration of the second doped region can be 1×10¹¹-1×10²¹/cm³. Optionally, the doping concentration of the first doped region can be 1×10¹⁰-5×10¹⁸/cm³, and the doping concentration of the second doped region can be 1×10¹²-5×10²⁰/cm³. Further optionally, the doping concentration of the first doped region can be 1×10¹⁰-1×10¹⁸/cm³, and the doping concentration of the second doped region can be 1×10¹²-1×10²⁰/cm³.

In a specific embodiment, in the back-field doped layer, on the condition that the first doped region is made of doped microcrystalline silicon, the crystallinity of the second doped region can be greater than that of the first doped region. For example, the crystallinity of the first doped region can be 5% to 40%, and the crystallinity of the second doped region can be 6% to 70%. Further, the crystallinity of the second doped region can be 15% to 70%. Alternatively, the crystallinity of the second doped region can be 30% to 70%. Further, the crystallinity of the second doped region can be 50% to 70%.

In a specific embodiment, the conducting layer can be a transparent conducting thin film, and the conducting layer covers the entire doped layer. Specifically, the conducting layer in the emission member is an emission conducting layer, and the emission conducting layer covers the entire emission doped layer. The conducting layer in the back surface field member can be a back surface field conducting layer, and the back surface field conducting layer covers the entire back surface field doped layer.

In a specific embodiment, the electrode layer includes a grid line electrode. Optionally, the electrode layer is a metal grid line electrode. The thickness of the metal grid line electrode can be 5µm to 200µm. The pattern of the metal grid line electrode can coincide with the pattern of the corresponding second doped region. Specifically, the electrode layer in the emission member is an emission electrode layer. The pattern of the emission electrode layer can coincide with the pattern of the second doped region in the emission doped layer. The electrode layer in the back surface field member is a back surface field electrode layer. The pattern of the back surface field electrode layer can coincide with the pattern of the second doped region in the back surface field doped layer.

According to another aspect, the preparation of the electrical contact reinforced structure in any of the above embodiments can include following steps: Form a precursor of the doped layer, having a uniform doping concentration, and perform laser-doping on a predetermined region of the second doped region to increase the doping concentration of the second doped region; and/or form a precursor of the doped layer, having a uniform doping concentration, and perform laser-induced crystallization on a predetermined region of the second doped region to increase the crystallization degree of the second doped region. After forming the second doped region, the conducting layer that entirely covers the doped layer can be further formed, and an electrode layer that shields the second doped region can be further formed. It can be understood that the above preparation steps are primarily intended to illustrate how to prepare a doped layer having a second doped region, and other layers can be prepared in a suitable manner selected by those skilled in the art.

The laser-doping refers to laser bombarding a doping source and a semiconductor material to dope the semiconductor material with impurity atoms by using the local high energy density laser. The laser-induced crystallization refers to generation of thermal effect on a surface of a semiconductor material by using a laser, so that the semiconductor material instantaneously reaches an extremely high temperature, thereby rendering sufficient phase transition energy and being converted into a crystalline state, which can improve the crystallinity. An advantage of using laser-doping and/or laser-induced crystallization is that the laser has high positioning accuracy, which facilitates the formation of the second doped region with a very small width. In addition, it requires only one laser irradiation device to increase the crystallinity or doping concentration in the actual preparation process. It can be understood that the crystallinity, doping concentration, thickness, etc. of the second doped region can be controlled by controlling the parameters during the specific process of the preparation.

More preferably, the doping concentration and crystallization degree of the second doped region are both higher than those of the first doped region. By having both of the doping concentration and crystallization degree of the second doped region higher than those of the first doped region, a further significant increase in the fill factor, open-circuit voltage, and short-circuit current of the heterojunction solar cell can be achieved. Meanwhile, during forming the electrical contact reinforced structure, the laser-induced crystallization and the laser-doping can be performed on the second doped region at the same time by controlling the laser irradiation energy. In this way, the process which would normally take two steps can be completed by only one step.

In combination with the above method for preparing the electrical contact reinforced structure, the present disclosure also provides a method for preparing the heterojunction solar cell, specifically including the following steps:
Step S1, texture and clean an N-type monocrystalline silicon substrate layer.
Step S2, deposit a first passivation layer and a second passivation layer respectively on a front side and a back side of the N-type monocrystalline silicon substrate layer. The first passivation layer and the second passivation layer can be deposited by plasma enhanced chemical vapor deposition, catalytic chemical vapor deposition, etc.
Step S3, deposit an emission doped layer on the first passivation layer, and deposit a back surface field doped layer on the second passivation layer.

Specifically, a P-type doped silicon film can be firstly deposited by plasma enhanced chemical vapor deposition, catalytic chemical vapor deposition, etc., and then laser-doping and laser-induced crystallization can be performed to form a second doped region, leaving the rest region as a first doped region. The doping concentration and crystallization degree of the second doped region are both higher than those of the first doped region. The parameters of the second doped region, such as the doping concentration, crystallization degree, thickness, etc., can be correspondingly controlled by regulating the parameters such as the laser power, irradiation time, amount of the doping source, etc. The back surface field doped layer can be prepared by a similar process, except that the doping type of the back surface field doped layer is N-type.

Step S4, form conducting layers respectively on a surface of the emission doped layer and a surface of the back surface field doped layer away from the substrate layer. Specifically, the conducting layer is a transparent conducting film. The specific method for forming the conducting layer can be radio frequency sputtering, direct current sputtering, or pulse sputtering.

Step S5, form electrode layers respectively on both side surfaces of the conducting layers away from the substrate layer. Specifically, the electrode layers include metal grid line electrodes. The method for forming the metal grid line electrodes can be as screen printing, evaporation, magnetron sputtering, ink jet printing, etc.

In order to facilitate understanding of the heterojunction solar cell in any of the above embodiments, a specific structure of the heterojunction solar cell is shown in FIG. 1. The heterojunction solar cell includes a substrate layer 100, a first passivation layer 101, an emission doped layer 111, an emission conducting layer 112, an emission electrode layer 113, a second passivation layer 102, a back surface field doped layer 121, a back surface field conducting layer 122, and a back surface field electrode layer 123. The first passivation layer 101, the emission doped layer 111, the emission conducting layer 112, and the emission electrode layer 113 are sequentially stacked on the front side of the substrate layer 100. The second passivation layer 102, the back surface field doped layer 121, the back surface field conducting layer 122, and the back surface field electrode layer 123 are sequentially stacked on the back side of the substrate layer 100. The emission doped layer 111, the emission conducting layer 112, and the emission electrode layer 113 constitute an emission member, and the back surface field doped layer 121, the back surface field conducting layer 122, and the back surface field electrode layer 123 constitute a back surface field member.

The substrate layer 100 is an n-type monocrystalline silicon substrate layer that has been cleaned and textured, with a thickness of 200µm. The first passivation layer 101 and the second passivation layer 102 are both hydrogen-containing intrinsic amorphous silicon. The first passivation layer 101 and the second passivation layer 102 each have a thickness of 10 nm.

The emission doped layer 111 is overall made of p-type doped silicon. The emission doped layer 111 includes a first emission doped region 1111 and a second emission doped region 1112. The second emission doped region 1112 is located beside the first emission doped region 1111. The doping concentration and the crystallization degree of the second emission doped region 1112 are both higher than those of the first emission doped region 1111. The emission conducting layer 112 is stacked on the first doped layer and covers the first doped layer. The emission conducting layer 112 is a transparent conducting layer. The emission electrode layer 113 includes a grid line electrode, which is disposed corresponding to the position of the second emission doped region 1112. The width of the grid line electrode is equal to the width of the second emission doped region 1112. FIG. 1 only shows two second emission doped regions 1112, though an actual heterojunction solar cell may include even more second emission doped regions 1112.

The back surface field doped layer 121 is overall made of n-type doped silicon. The back surface field doped layer 121 includes a first back surface field doped region 1211 and a second back surface field doped region 1212. The second back surface field doped region 1212 is located beside the first back surface field doped region 1211. The doping concentration and the crystallization degree of the second back surface field doped region 1212 are both higher than those of the first back surface field doped region 1211. The back surface field conducting layer 122 is stacked on the second doped layer and covers the second doped layer. The back surface field conducting layer 122 is a transparent conducting layer. The back surface field electrode layer 123 includes a grid line electrode, which is disposed corresponding to the position of the second back surface field doped region 1212. The width of the grid line electrode is equal to the width of the second back surface field doped region 1212. FIG. 1 only shows two second back surface field doped regions 1212, though an actual heterojunction solar cell may include even more second back surface field doped regions 1212.

Yet another embodiment of the present disclosure provides a power generation device, including the heterojunction solar cell in any of the above embodiments.

In order to make the present disclosure be more readily understood and realized, the following specific and detailed examples and comparative examples that are easy to be implemented are provided for reference. The embodiments of the present disclosure and their advantages will also be apparent from the following description of the specific examples, the comparative examples, and the performances thereof.

### Example 1

A heterojunction solar cell is prepared by the method including the following steps:
Texture and clean an N-type monocrystalline silicon substrate layer.

Deposit hydrogen-containing intrinsic amorphous silicon films respectively on the front side and the back side of the N-type monocrystalline silicon substrate layer as a first passivation layer and a second passivation layer.

Deposit a P-type doped amorphous silicon thin film on the first passivation layer, and perform laser-doping by laser irradiating a predetermined region in a doping source, while increase the laser irradiation energy to perform laser-induced crystallization, thereby forming the predetermined region into a second doped region, and leaving the untreated region as a first doped region. The doping concentration of the first doped region is 5×10¹⁷, and the crystallinity of the first doped region is 0%. The doping concentration of the second doped region is 5×10¹⁹, the crystallinity of the second doped region is 10%, and the width of the second doped region is 20µm.

Deposit an N-type doped amorphous silicon thin film on the second passivation layer, perform laser-doping by laser irradiating a predetermined region in a doping source, while increase the laser irradiation energy to perform laser-induced crystallization, thereby forming the predetermined region into a second doped region, and leaving the untreated region as a first doped region. The doping concentration of the first doped region is 5×10¹⁸, and the crystallinity of the first doped region is 0. The doping concentration of the second doped region is 5×10¹⁹, the crystallinity of the second doped region is 15%, and the width of the second doped region is 25µm.

Sputter a conducting layer on each of the emission doped layer and the back surface field doped layer at the side away from the substrate layer.

Screen-print a silver grid line electrode on the surface of each of the conducting layers at the side away from the substrate layer.

### Example 2

Example 2 is substantially the same as Example 1, and the main difference lies in that only laser-doping is performed in depositing the P-type doped amorphous silicon thin film and depositing the N-type doped amorphous silicon thin film, without performing laser-induced crystallization.

### Example 3

Example 3 is substantially the same as Example 1, and the main difference lies in that only laser-induced crystallization is performed in depositing the P-type doped amorphous silicon thin film and depositing the N-type doped amorphous silicon thin film, without performing laser-doping.

### Comparative Example 1

Comparative Example 1 is substantially the same as Example 1, and the main difference lies in that neither laser-induced crystallization nor laser-doping is performed in depositing the P-type doped amorphous silicon thin film and depositing the N-type doped amorphous silicon thin film.

The open-circuit voltage, short-circuit current, and fill factor of Examples 1 to 3 and Comparative Example 1 are tested. The results are shown in Table 1 (the results of Comparative Example 1 are 1.0, and the results of Examples 1 to 3 are normalized).

**Table 1**

| | Conversion efficiency | Open-circuit voltage | Short-circuit current | Fill factor |
|---|---|---|---|---|
| Example 1 | 1.0047 | 1.0002 | 1.0009 | 1.0059 |
| Example 2 | 1.0027 | 1.0003 | 1.0011 | 1.0032 |
| Example 3 | 1.0021 | 0.9999 | 1.0009 | 1.0021 |
| Comparative Example 1 | 1.0000 | 1.0000 | 1.0000 | 1.0000 |

The technical features of the above embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims, the description and drawings may be used to illustrate the content of the claim.

## Claims

1. A heterojunction solar cell, comprising a substrate layer, a first passivation layer, a second passivation layer, an emission member, and a back surface field member;
wherein a doping type of the substrate layer is N-type or P-type, the first passivation layer is disposed on a first surface of the substrate layer, the emission member is disposed on a surface of the first passivation layer away from the substrate layer, the second passivation layer is disposed on a second surface of the substrate layer opposite to the first surface, the back surface field member is disposed on a surface of the second passivation layer away from the substrate layer; the emission member and the back surface field member each comprise a doped layer, a conducting layer, and an electrode layer sequentially disposed along a direction away from the substrate layer; the doping type of the doped layer in the back surface field member is the same as the doping type of the substrate layer, and the doping type of the doped layer in the emission member is opposite to the doping type of the substrate layer;
one or both of the emission member and the back surface field member comprise an electrical contact reinforced structure, and the electrical contact reinforced structure is a first doped region and a second doped region of the doped layer, wherein the second doped region is disposed beside the first doped region and is shielded by the electrode layer, and one or both of doping concentration and crystallization degree of the second doped region are higher than those of the first doped region.

2. The heterojunction solar cell of claim 1, wherein the electrode layer comprises a grid line electrode, the second doped region is shielded by the grid line electrode, and a width of the grid line electrode is larger than a width of the second doped region.

3. The heterojunction solar cell of claim 2, wherein the second doped region is a plurality of second doped regions, and the plurality of second doped regions are disposed at intervals; the grid line electrode is a plurality of grid line electrodes, and the plurality of grid line electrodes are disposed at intervals.

4. The heterojunction solar cell of claim 2, wherein the width of the second doped region is 5µm to 200µm.

5. The heterojunction solar cell of any one of claims 1 to 4, wherein the second doped region is exposed from a surface of the doped layer away from the substrate layer and is in contact with the conducting layer.

6. The heterojunction solar cell of claim 5, wherein the doped layer in the emission member is an emission doped layer, the first doped region in the emission doped layer is made of doped amorphous silicon, and the emission doped layer has a thickness of 6nm to 15nm.

7. The heterojunction solar cell of claim 5, wherein the first doped region in the emission doped layer is made of doped microcrystalline silicon, and the emission doped layer has a thickness of 15nm to 30nm.

8. The heterojunction solar cell of claim 6 or 7, wherein the doped layer in the back surface field member is a back surface field doped layer, the first doped region in the back surface field doped layer is made of doped amorphous silicon, and the back surface field doped layer has a thickness of 4nm to 10nm.

9. The heterojunction solar cell of claim 6 or 7, wherein the first doped region in the back surface field doped layer is made of doped microcrystalline silicon, and the back surface field doped layer has a thickness of 15nm to 30nm.

10. A method for preparing a heterojunction solar cell, wherein the heterojunction solar cell comprises a substrate layer, a first passivation layer, a second passivation layer, an emission member, and a back surface field member;
a doping type of the substrate layer is a first doping type, the first passivation layer is disposed on a first surface of the substrate layer, the emission member is disposed on a surface of the first passivation layer away from the substrate layer, the second passivation layer is disposed on a second surface of the substrate layer opposite to the first surface, the back surface field member is disposed on a surface of the second passivation layer away from the substrate layer; the emission member and the back surface field member each comprise a doped layer, a conducting layer, and an electrode layer sequentially disposed along a direction away from the substrate layer; the doping type of the doped layer in the back surface field member is the first doping type, and the doping type of the doped layer in the emission member is a second doping type;
one or both of the emission member and the back surface field member comprise an electrical contact reinforced structure, and a method for forming the electrical contact reinforced structure comprises one or both of step a and step b:
a. forming a precursor layer of the doped layer, and performing laser-doping on a predetermined region to increase doping concentration of the predetermined region, thereby forming the second doped region;
b. forming a precursor layer of the doped layer, and performing laser-induced crystallization on a predetermined region to increase crystallization degree of the predetermined region, thereby forming the second doped region.

11. The method of claim 10, wherein in the electrical contact reinforced structure, both of the doping concentration and the crystallization degree of the second doped region are higher than the doping concentration and the crystallization degree of the first doped region.

12. The method of claim 11, wherein during the forming of the electrical contact reinforced structure, both the laser-doping and the laser-induced crystallization are performed on the second doped region at the same time.

13. The method of claim 10, wherein the electrode layer comprises a grid line electrode, the second doped region is shielded by the grid line electrode, and a width of the grid line electrode is larger than a width of the second doped region.

14. The method of claim 13, wherein the second doped region is a plurality of second doped regions, and the plurality of second doped regions are disposed at intervals; the grid line electrode is a plurality of grid line electrodes, and the plurality of grid line electrodes are disposed at intervals.

15. The method of claim 13, wherein the width of the second doped region is 5µm to 200µm.

16. The method of any one of claims 10 to 15, wherein the second doped region is exposed from a surface of the doped layer away from the substrate layer and is in contact with the conducting layer.

17. The method of claim 16, wherein the doped layer in the emission member is an emission doped layer, the first doped region in the emission doped layer is made of doped amorphous silicon, and the emission doped layer has a thickness of 6nm to 15nm.

18. The method of claim 16, wherein the first doped region in the emission doped layer is made of doped microcrystalline silicon, and the emission doped layer has a thickness of 15nm to 30nm.

19. The method of claim 17 or 18, wherein the doped layer in the back surface field member is a back surface field doped layer, the first doped region in the back surface field doped layer is made of doped amorphous silicon, and the back surface field doped layer has a thickness of 4nm to 10nm.

20. The method of claim 17 or 18, wherein the first doped region in the back surface field doped layer is made of doped microcrystalline silicon, and the back surface field doped layer has a thickness of 15nm to 30nm.

21. A power generation device, comprising the heterojunction solar cell of any one of claims 1 to 9.
